# EUROPEAN PATENT SPECIFICATION

(11) **EP 2 601 678 B1**
(45) Date of publication and mention of the grant of the patent: **07.10.2015**
(21) Application number: 11760848.9
(22) Date of filing: 02.08.2011
(51) Int. Cl.: H01L 21/335, H01L 29/423, H01L 29/778, H01L 29/40, H01L 21/285

(54) **MANUFACTURING OF SCALABLE GATE LENGTH HIGH ELECTRON MOBILITY TRANSISTORS**
HERSTELLUNG VON TRANSISTOREN MIT HOHER ELEKTRONENMOBILITÄT UND SKALIERBARER GATELÄNGE
FABRICATION DE TRANSISTORS À GRANDE MOBILITÉ D'ÉLECTRONS ET LONGUEUR DE GRILLE RÉGLABLE

(30) Priority: 02.08.2010 IT TO20100668
(43) Date of publication of application: 12.06.2013
(73) Proprietor: SELEX ES S.p.A., 00195 Roma (IT)
(72) Inventor: PERONI, Marco, I-00195 Roma (IT); ROMANINI, Paolo, I-00195 Roma (IT)
(74) Representative: Bergadano, Mirko
(86) International application number: PCT/IB2011/053438
(87) International publication number: WO 2012/017389

(56) References cited:
- EP-A1- 2 015 353
- EP-A2- 0 592 064
- US-A1- 2007 215 899
- US-A1- 2008 179 694
- US-A1- 2008 211 052
- VETURY R ET AL: "Performance and RF Reliability of GaN-on-SiC HEMT's using Dual-Gate Architectures", MICROWAVE SYMPOSIUM DIGEST, 2006. IEEE MTT-S INTERNATIONAL, IEEE, PI, 1 June 2006 (2006-06-01), pages 714-717, XP031018573, DOI: DOI:10.1109/MWSYM.2006.249733 ISBN: 978-0-7803-9541-1 cited in the application

## Description

### TECHNICAL FIELD OF THE INVENTION

The present invention relates in general to High Electron Mobility Transistors (HEMTs), and in particular to the manufacturing of HEMTs with scalable gate length, fixed gate section area, and low gate-source and drain-source current leakage.

### STATE OF THE ART

It is known that Monolithic Microwave Integrated Circuits (MMIC) used in high-power and/or high-frequency applications are called to perform various radio frequency (RF) functions, such as switching, low noise amplification and power amplification, as, for example, required by front-ends transmission and reception modules operating in the microwave frequency band, in both narrowband and broadband.

The growing market demand for MMICs with increasingly better performance features has pointed the electronic industry towards HEMTs, the electric features of which are such to allow such a growing demand to be satisfied. However, the different required MMIC RF functions imply implementation needs which may be even very different, the satisfaction of which requires the use of HEMTs with equally different performance.

The electric features of the semiconductor material of which the HEMT is made are beyond doubt of primary importance among the features which have greater incidence on HEMT performance. Thus, the different RF functions that the integrated circuits may be called to perform, such as the development of new RF functions, inevitably imply the use of semiconductor material layers of different thickness, composition and doping features made so as to obtain the desired electric features of the HEMT. Because the HEMT manufacturing process is bound to the features of the original semiconductor material, the different features mentioned above consequently imply the adoption or development of different HEMT manufacturing processes.

Furthermore, some applications may require that a same MMIC implements different RF functions. In these applications, the HEMTs needed for the required integrated RF circuit functions are all made on a same substrate, the electric features of which can only be the result of a compromise between the various HEMT performance requests, which may - and frequently does - give rise to criticalities concerning global MMIC performance.

It is further worth noting that for making Group III-V Arsenic-based epitaxial semiconductor material multifunctional devices, low-damage chemical or chemical/physical etching is often performed for each MMIC device so that the electric contacts of the electrodes of such devices are deposited on the surface on the semiconductor layer of the epitaxial surface to have the desired optimal functionality. This approach is, in all cases, difficult to use for Group-III Nitrides, such as those used for the manufacturing of GaNHEMTs, due to the further difficulty of making low-damage etching, e.g. for making the gate recess, because of the higher energy needed to erode such semiconductor layers.

Such criticalities are accentuated when the HEMTs present in MMIC amplifier circuits operating in the higher frequency spectrum from microwaves to millimeter waves must be made, in particular when a particularly broad operating spectrum is required (such as integrated multi-band amplifier circuits). In such a case, an increase of HEMT cutoff frequencies is required, meaning the frequency associated to the unitary current gain (f_{T}) and that associated to the unitary power gain (f_{MAX}), which implies a decrease of the control gate length in order to decrease the parasitic capacitance thereof. Although the geometric variation of the control gate junction allows to reach such an advantage, it may be associated to the variation of other characteristic parameters of the HEMTs, which may have a negative influence on the increase of cutoff frequencies f_{T} and f_{MAX} itself. A variation is bound to the decrease of control gate metallization section area, which implies an increase of the parasitic resistance to the detriment of the increase of cutoff frequency f_{MAX}. Such a problem is partially overcome by making a "T", "Γ" or "Y"-shaped geometry of the control gate metallization, which allows to make a junction (control gate foot) with short contact length, combined, towards the upper part thereof, with an extension of the metallization itself (control gate head) of larger size and raised with respect to the gate foot. The difference between side dimensions of the control gate head and gate foot, as the height of the gate head with respect to the base of the gate foot, cannot, in all cases, exceed given limits without sensibly increasing the mechanical fragility of the metallization itself, with consequent negative consequences on manufacturing efficiency of the HEMT devices themselves, thus limiting, in fact, the decrease of control gate junction length for a fixed area of the section and parasitic capacitance associated to the extension of the gate head. The control gate metallization section area for a fixed requirement on its parasitic resistance is then functional to the different HEMT sizes, which must be greater the more extended the width, as typically made for devices of larger size, in particular when use thereof is required for power applications, while it may be lower for smaller devices, as generally implemented in the devices used in low-noise amplifier circuits.

The decrease of the control gate junction length further generally implies a decrease of HEMT transconductance, frequently described as "short channel effect", which also has negative consequences on the increase of cutoff frequencies f_{T} and f_{MAX}. Such an effect is more marked when the HEMT is biased for low drain currents and high drain voltages, conditions which are typically reached in high power applications. This aspect also implies greater criticality due to the control gate length reduction when HEMTs optimized for high power amplifier applications must be made with respect to low noise applications, in which in order to improve the RF noise features the tendency is to optimize the HEMT features so that the optimal biasing thereof is at the lowest possible drain electrode biasing voltages.

The short channel effect generally attributed to a lack of confinement of the channel electrons in presence of high electric fields may be mitigated by doping with incorporation of acceptor impurities (generally Iron or carbon atoms) within the buffer semiconductor layer located underneath the electron channel made uniformly on the entire wafer area during a step of epitaxial growth, because such an area doped in this manner acts as a barrier to the diffusion of the electrons in the channel. The concentration and the profile of such doping must, in all cases, be optimized also to obtain the best compromise between short channel effect control and donor impurity compensation in the buffer layer, often unintentionally introduced during epitaxial growth, and the increase of the two-dimensional electron gas resistance caused by the presence of acceptor impurities, consequent to their effect on the decrease of both charge concentration and channel electron mobility. From the point of view of the electric features of the HEMT and the RF amplification gain, if on one side the effect of such a doping allows to increase both transconductance and output impedance of the device (as advantages of the increase of f_{T} and f_{MAX}), the uniform distribution of acceptor impurities in the buffer on the entire surface of the wafer leads to an increase of resistance and decrease of charge also in the channel portions present in the active channel by the sides of the control gate, causing an increase of the parasitic access resistances to the intrinsic device and a decrease of the maximum drain current which have the negative consequence of producing a RF gain drop, an increase of the noise figure and a lower output power the biasing voltage being equal.

The acceptor impurity doped buffer layer has the further effect of reducing electric fields ion proximity of the control gate junction, thus contributing to limiting the control gate parasitic current the biasing being equal, and thus mitigating the decay of the semiconductor features and of the electric junctions of the devices made therewith, and of increasing the break down voltage, thus allowing to increase the possible drain electrode biasing limits to the advantage of maximum HEMT RF power. Precisely for this purpose, the technique which consists in applying an acceptor impurities doping is, for example, implemented in Low Doping Drain (LDD) MOSFET power devices made of Silicon (Si), but, in this case, the doping profile is confined only under the channel at the control gate and on the side towards the drain electrode, so that it is optimal for the best compromise to obtain low parasitic resistance and low electric fields.

Other solutions, of the type described by R. Vetury, J.B. Shealy, D. S. Green, J. McKenna, J. D. Brown, K. Leverich, P. M. Garber and M. J. Poulton in the conference paper entitled "Performance and RF Reliability of GaN-on-SiC HEMTs using Dual-Gate Architectures", submitted to the Proceedings of the 2006 International Microelectronics Symposium and appearing in Microwave Symposium Digest, 2006, IEEE MTT-S International, 11-16 June 2006, pages 714-717, are generally used to protect the HEMT from high electric fields, but may be detrimental to some performances, and must thus be optimized according to the chosen function. This is frequently achieved, in particular in the manufacturing of GaN HEMTs, with the introduction of further metallizations over the HEMT channel, between the control gate and the drain electrode, generally named Field Plates, either single or multiple, connected to a ground electric potential, which form a Schottky or Metal-Insulating Semiconductor (MIS) junction with the electrodes of the channel between the control gate and the drain electrode, the effect of which is to reduce the maximum peak intensity of the electric field in the semiconductor material, for a fixed biasing of the device.

Parasitic capacitances which have the effect of reducing the high frequency gain and/or bandwidth thereof are, in all cases, associated to the presence of such metallizations. Furthermore, the use of a double Schottky junction connected directly to an electric ground potential on one hand allows to drastically reduce the electric field but also has the negative effect of limiting the drain electrode current when the control gate voltage assumes positive values, thus reducing the width dynamics of the output signal, and consequently the linearity and maximum power of the amplified RF signal.

Furthermore, it is worth noting that reducing the electric field in the channel the drain voltage being correspondingly equal also increases the knee voltage V_{DS}^{K}, i.e. the voltage at which the features of the drain current I_{D} as a function of the Drain-Source voltage reaches a saturation value. Such an increase of knee voltage V_{DS}^{K} makes it necessary to use higher voltages, and thus greater dissipations, which usually do not benefit low-noise, high-frequency performance. Thus, such Field Plate solutions, particularly when introduced in high-frequency HEMTs, while being preferable for high-power applications could be counterproductive for low-noise amplification.

Other solutions are described in N. Miura, T. Oishi, T. Nanjo, M. Suita, Y. Abe, T. Ozeki, H. Ishikawa and T. Egawa: "Effects of Interfacial Thin Metal Layer for High-Performance Pt-Au-Based Schottky Contacts to AlGaN-GaN", IEEE TRANSACTIONS ON ELECTRON DEVICES, pp.297-303, VOL. 51, NO. 3, MARCH 2004, and in N. Miura, T. Nanjo, M. Suita, T. Oishi, Y. Abe, T. Ozeki, H. Ishikawa, T. Egawa, T. Jimbo "Thermal annealing effects on Ni/Au based Schottky contacts on n-GaN and AlGaN/GaN with insertion of high work function metal", Solid-State Electronics 48 (2004), pages 689-695, in which, however, the annealing process of a Nickel/Platinum metallization in presence of Gold or other low electric resisitivity metallization does not guarantee an interdiffusion between Gold (Au), Nickel (Ni) and Platinum (Pt) during the thermal annealing cycle, with the risk of forming an Au/Ni alloy in the gate metallization which has worse resistance than that of the deposited Gold layer, with negative consequences on the parasitic resistance of the control gate. Furthermore, a risk of the mentioned annealing process is to accelerate the Gold diffusion process in the semiconductor through the underlying Ni or Ni/Pt metal layer forming the Schottky barrier, thus worsening the rectifying features of the Schottky junction with negative effects on device reliability, as demonstrated in literature by Helmut Jungl, Reza Behtashl, James R. Thorpel, Klaus Riepel, Franck Bourgeois, Hervé Blanck, Andrey Chuvilin and Ute Kaiser in the article entitled "Reliability behavior of GaN HEMTs related to Au diffusion at the Schottky interface" Physica Status Solidi, Volume 6, Issue supplement 2, pages 976-979, June 2009.

A further solution is described in EP 0 592 064 A2, wherein the control gate metallization is performed in two steps of deposition and a thermal annealing cycle is performed after the first and before the second step of deposition. However, the manufacturing process of the control gate described in this document requires that the first metallization is deposited by means of a sputtering process on the entire surface of the semiconductor, either at a metal layer or over a dielectric layer. This is necessary because deposition by sputtering induces a mechanical damage to the semiconductor material which is much more significant than that induced by a previous etching process of the dielectric layer or of the semiconductor layer.

US 2008/179694 A1 discloses a FET in which a second nitride semiconductor layer is provided on a first nitride semiconductor layer, and a source electrode and a drain electrode are each provided to have at least a portion thereof in contact with the second nitride semiconductor layer, A concave portion is formed in the upper surface of the second nitride semiconductor layer to be located between the source electrode and the drain electrode. Then, by using, e.g., an electron beam deposition method and a lift-off method, a gate electrode is buried in the concave portion and provided on the upper surface of the second nitride semiconductor layer so as to cover the opening of the concave portion.

EP 2 015 353 A1 discloses a semiconductor device, which can prevent an element breakdown by alleviating of electric field concentrations, and can also prevent a gain reduction. The semiconductor device includes a source electrode formed on a semiconductor layer; a drain electrode formed on the semiconductor layer; a gate electrode formed between the source electrode and the drain electrode; an insulating film formed on the semiconductor layer and the gate electrode; a field plate electrode formed on the insulating film; and a resistor for connecting the field plate electrode and the source electrode.

### OBJECT AND SUMMARY OF THE INVENTION

It is thus an object of the present invention to make available a HEMT manufacturing technology which allows to overcome the drawbacks of the known manufacturing technologies described above, in particular which allows to optimize the performance of HEMTs for different RF functions without needing to modify the features, in terms of composition and/or doping, of the semiconductor material with which the HEMTs are manufactured, and consequently the manufacturing processes of the same.

This object is reached by the present invention, which relates to a process of manufacturing a HEMT and to a HEMT thereby obtained, as defined in the appended claims.

In particular, the optimization of HEMT performance for different RF functions is reached by acting on the electric features of the semiconductor material of which the control gate is made instead of on the electric features of the HEMT. This allows to vary, starting from a same semi-insulating substrate, the electric features of each single HEMT made on such semi-insulating substrate, if needed also locally, with respect to the electric features available in a single type of transistors which performs the various RF functions. This further allows to make an integrated RF circuit optimized for multiple RF functions, with economic advantages, above all during the step of assembly, with respect to the current making of modules in which multiple MMIC are present, each optimized for a respective RF function, thus mitigating the global MMIC performance criticalities deriving from the compromise concerning the choice of electric features of the HEMT in common to all functions.

In detail, the electric features of the control gate are optimized by performing a double selective metallization, between which a thermal stabilization and annealing treatment is performed to remove the damage introduced by the previous steps of manufacturing, such as chemical etching, deposition or other.

During the first metallization, only the lower part of the control gate is selectively deposited so as to make a Schottky junction with the semiconductor layer underneath of minimum size of a few tens of nm, that, along with the surrounding passivation layer, makes an encapsulation of the surface during the subsequent thermal treatment. During the second metallization, the remaining upper part of the control gate is instead selectively deposited so as to obtain, independently from the geometry of the lower part of the same, a compromise between parasitic resistance and capacitance, thus mitigating the greater mechanical fragility criticality associated to the smaller contact length of the gate base, no longer being more equivalent to the length of the Schottky junction, which is, instead, equivalent to that of the opening of the gate foot made during the first metallization. Additionally, metals which are not necessarily compatible with high temperature thermal cycles used during the step of forming of the lower part of the control gate can be used during this second step.

In particular, the selective deposition of the control gate metallization is performed, in both steps, by means of a lift-off process, i.e. by exploiting the same photolithographic resist mask used for opening the window in which the control gate is subsequently made by means of chemical etching in a dielectric layer, then by eliminating the metal not present over the surface of the semiconductor and present over the resist mask by dissolving the resist forming the mask with solvents. This process further allows to perform the thermal annealing cycle between the two steps of deposition, because the surface of the semiconductor is thus either protected by the dielectric layer, or only the metallizations of the ohmic contacts and of the Schottky contact are present in its openings. The thermal annealing process at temperatures higher than 400°C, in addition to tempering the semiconductor material damaged by the chemical etching for the creation of the opening in which the control gate is then made, if applied to metal layers such as Nickel or Platinum, has been proven to have the effect of improving the rectifying features of the Schottky junction.

It is further possible to perform, either individually or in combination, an acceptor impurity implantation aligned with the control gate to improve the short channel effect, a second electrode with Schottky junction for making a Schottky field plate which allows to increase the HEMT RF gain, especially when high drain voltages are reached, and a HEMT with Metal-Insulating Semiconductor junction (MIS) integrated with the HEMT with Schottky junction.

### BRIEF DESCRIPTION OF THE DRAWINGS

- Figures 1-3 are schematic section views of a HEMT
- Figures 4-6 are schematic section views of a HEMT according to the invention;
- Figure 7 is a plan view of the HEMT in figure 6; and
- Figure 8 is a schematic section view of a HEMT with Metal-Insulating Semiconductor control gate.

### DETAILED DESCRIPTION OF PREFERRED EMBODIMENTS OF THE INVENTION

The present invention will now be described in detail with reference to the appended figures in order to allow a person skilled in the art to make it and use it. Various changes to the described embodiments will be immediately apparent to people skilled in the art, and the described generic principles may be applied to other embodiments and applications without because of this departing from the scope of protection of the present invention, as defined in the appended claims. Therefore, the present invention must not be considered limited to the described and illustrated embodiments but instead confers the broadest scope of protection, in accordance with the principles and features described and claimed herein.

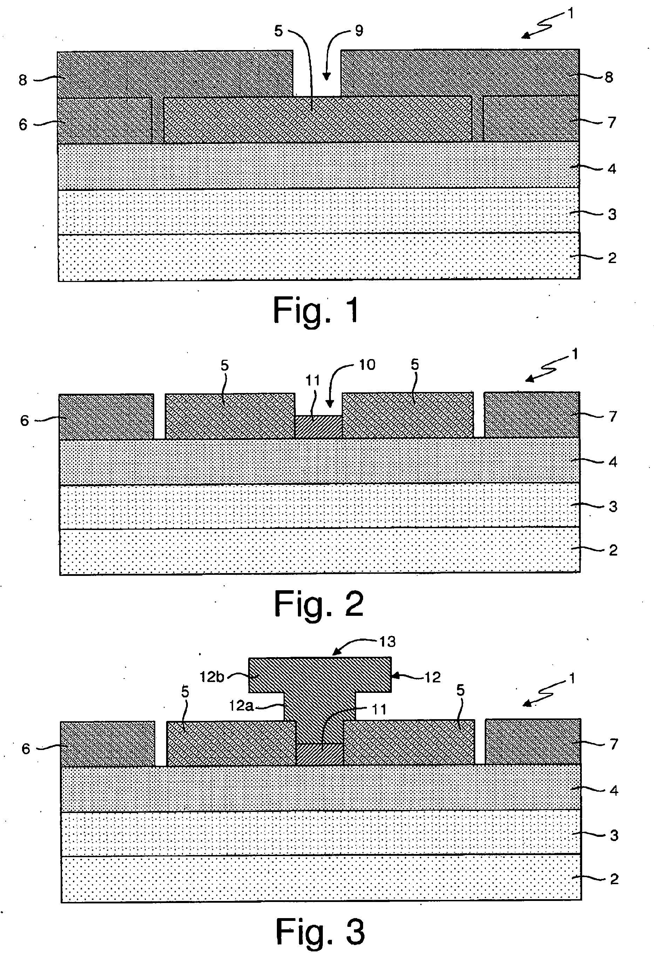

Figures 1-3 schematically illustrate in section view a HEMT according to an example helping to understand the present invention during different steps of the manufacturing process thereof.

In particular, in Figure 3 numeral 1 indicates as a whole a HEMT comprising:
- an epitaxial substrate comprising:
   - a semi-insulating substrate 2, generally made of semiconductor material, e.g. Silicon (Si), Silicon Carbide (SiC), Gallium Nitride (GaN) or Sapphire (Al₂O₃);
   - a buffer layer 3, preferably comprising a Nitride of a Group III element, such as Gallium Nitride or Aluminum Gallium and/or Indium (GaN/AlGaN/InGaN/AlInGaN), conveniently Gallium Nitride (GaN), formed on the semi-insulating substrate 2, possibly by interposition of other layers; and
   - a barrier layer 4, preferably also comprising a Nitride of a Group III element, in particular Gallium Nitride, Indium and Aluminum (InAlGaN), formed on the buffer layer 3, possibly in turn formed by layers with variation of composition and doping; and
   - a mechanical and/or passivation layer 5, preferably made of dielectric material, such as Silicon Nitride (SiN), Silicon Dioxide (SiO₂) or formed by several superimposed layers formed thereby, formed on the barrier layer 4 and in which exposed portions of the barrier layer 4 are left defining a first and a second ohmic contact region;
- a source electrode 6 and a drain electrode 7 formed respectively on, and in ohmic contact with, the exposed portions of the barrier layer 4, in the first and second ohmic contact region, respectively;
- a control gate 13 formed on, and in Schottky contact with the barrier layer 4, between the source 6 and the drain electrode 7, from which it is laterally separated.

One or more further passivation layer(s) can be then deposited on the mechanical protection and/or passivation layer 5 and on the ohmic contacts 6 and 7.

The source 6 and drain 7 electrodes are conveniently formed by forming a mask over the mechanical protection and/or passivation layer 5 conveniently formed by a photolithographic resist layer which is patterned so as to form a first and second window at the first and second ohmic contact region. The mechanical protection and/or passivation layer 5 is then chemically etched at the first and the second window to the interface with the barrier layer 4 and a metal deposition is thus performed at the exposed positions of the barrier layer 4, which leads to the formation of the source 6 and drain 7 electrodes. The HEMT 1 is thus subjected to a thermal cycle which binds the source 6 and drain electrodes 7 to the barrier layer 4 underneath, so as to form a non-rectifying (ohmic) contact between metal and electrons present in the channel.

In an alternative example? the source 6 and drain electrodes 7 may be formed on the barrier layer 4 before the mechanical protection and/or passivation layer 5, and the latter may then be deposited between the source 6 and drain 7 electrodes.

The source 6 and drain 7 electrodes may be conveniently formed so as to be smaller than the respective windows of the mechanical and/or passivation protection layer 5, so as to be distanced therefrom. Preferably, this difference between the size of the windows in the mechanical and/or passivation layer 5 and the windows of the source 6 and drain 7 electrodes is obtained by using an isotropic chemical etching, or partially such, for removing the mechanical protection and/or passivation layer 5, after having applied the mask for defining the source 6 and drain 7 electrodes and before metal deposition. Preferably, when the mechanical protection and/or passivation layer 5 is made by means of layers of Silicon Nitride (SiN) and/or Silicon Dioxide (SiO₂), the isotropic chemical etching may be obtained by immersion in a liquid solution based on the mixture of NH₄F, HF and H₂O.

In order to define the electrically conductive semiconductor areas of the MMIC surface on which active devices are made, with respect to the electrically non-conductive semiconductor areas, on which the passive components are generally made, the barrier layer 4 is made electrically insulated from the outside of the active area of the HEMT 1. This can be achieved after having firstly protected the surface which is desired to be left electrically conductive with a mask conveniently formed by an appropriately patterned photolithographic resist layer, and then by making electrically non-conductive the area not covered by such a mask by means of a bombarding process of the surface, e.g. by implanting fluoride ions at energy comprised between 50KeV and 300KeV and dose comprised between 5x10¹³ cm⁻² and 2x10¹⁴ cm⁻², or alternatively by removing the conductive parts of the semiconductor material present outside the mask, by operating a chemical-physical etching of the material not protected thereby to completely eliminate the barrier layer 4 outside and expose the buffer layer 3 underneath. For both procedures, the insulation process is performed before defining the control gate 13, as described below.

The control gate 13 is used for patterning the input signal and is made in the manner described below with reference to figures 1 and 2. As illustrated, on the mechanical and/or passivation layer 5 and on the first and second ohmic contact 6, 7 (and on any further passivation layers on these deposits) is formed a masking layer 8 provided with a through opening 9 which exposes a portion of the mechanical and/or passivation protection layer 5 between the ohmic contacts 6 and 7. Preferably, the masking layer 8 is a photolithographic resist layer, which is photolithographically patterned to form the opening 9, which can conveniently have minimum size in the order of several tens of nm.

A through window 10 is thus formed in the mechanical and/or passivation protection layer 5, at the opening 9 in the masking layer 8, so as to expose a surface of the barrier layer 4 defining a Schottky contact region in which the control gate 13 will then be made. In particular, the window 10 is made by means of selective low damage chemical etching which erodes the mechanical protection and/or passivation layer 5 to the interface with the barrier layer 4.

A lower portion 11 of the control gate 13, hereinafter named gate foot, is thus formed on the exposed portion of the barrier layer 4, in the window 10, by means of selective deposition by evaporation by means of a lift-off process, of a metallization comprising one or more metal element(s) with high working function, in particular equal to or higher than 5.0 eV,, and preferably Nickel and/or Platinum, conveniently both (see with this regard the aforementioned article *"Thermal annealing effects on Ni*/*Au based Schottky contacts on n-GaN and AlGaN*/*GaN with insertion of high work function metal"),* i.e. a deposition of multiple layers composed of metals with such features.

The deposition process of such metals may occur by means of low mechanical damage procedures, such as vacuum evaporation depositions, which cannot be performed, or which are difficult to performs, with refractory metals due to their intrinsic high fusion temperature. The interface of the semiconductor material towards the surface is, at the end of the definition of the gate foot 11 by metallization lift-off, only in the window 10 protected by compatible metals or by passivation layers in order to be able to apply the annealing process after gate foot deposition 11.

In particular, the gate foot 11 is formed so as to extend through the mechanical protection and/or passivation layer 5 by a height not higher than, and conveniently lower than, the total thickness of the mechanical protection and/or passivation layer 5 and possible further passivation layers, so as not to protrude from the window 10. This allows to facilitate the physical separation between the metal deposited on the barrier layer 4 and that deposited on the masking layer 8, and thus the subsequent removal of the latter metal by using the exposure to solvents (such as, for example, acetone or N-Methyl-2-pyrrolidone/NMP) of the masking layer, if it is composed by photolithographic resist, as in the example described above.

The HEMT 1 is thus subjected to a thermal stabilization and annealing treatment in order to remove the damage to the crystal lattice of the surface of the semiconductor from the previous steps of the process, such chemical etching, deposition and other, and stabilizing the metal-semiconductor interface of the Schottky junction. For an effective removal of the damage in a Nitride of a Group-III element, the temperatures reached during such a thermal treatment exceed 450°C, and thus may be higher than those of diffusion of Gold (Au) and/or of Aluminum (Al) in the previously mentioned metals and which form the Schottky barrier during the definition of the gate foot 11.

With reference again to figure 3, a higher portion 12 of the control gate 13, hereinafter indicated as gate head, is thus formed on the gate foot 11, e.g. by deposition of a metallization comprising one or more metal element(s), at least one of which a low reactivity, such as Gold (Au) or Aluminum (Al) with high thickness, possibly by means of the interposition, between the gate head 12 and the gate foot 11, of other barrier metal layers (such as Nickel (Ni) or Titanium (Ti), in order to limit the possibly of a chemical reaction with the gate foot 11.

In particular, the gate head 12 is formed so as to protrude from the window 10 and preferably display a first portion 12a which extends laterally onto the surface of the mechanical protection and/or passivation layer 5, outside the window 10, so as to rest on and be mechanically supported by the latter, thus improving mechanical adherence of the control gate 13 to the portions with which it is in contact, but without significantly increasing the global parasitic capacitance of the control gate 13. In other words, the gate head 12 is patterned so as to define in section, jointly with the gate foot 11, a stair-step profile at the first portion 12a.

The gate head 12 is further formed in a manner so as to present a second portion 12b vertically distanced from and extending laterally to one or both sides of the first portion 12a, so as to provide an optimized profile section to the gate head 12, e.g. the geometry of which assumes an aspect comparable to that of letters "T", "Y" or "r", to minimize parasitic capacitance and resistance of the control gate 13, allowing to use metals which are not necessarily compatible with the high temperature thermal cycles used in the first step of forming the gate foot 11.

In a preferred example in order to obtain the "T" "Y" or "Γ" geometry of the gate head 12, a process using electron beam lithography is used which, by impressing multiple resist layers, deposits the areas in which the mask must be formed by such resists with different thicknesses and sensitivity on the surface of the wafer, allowing to obtain openings, after the subsequent step of developing, the profile of which is optimized to provide the required geometry to the gate head metallization, in addition to facilitating the physical separation between deposited metal at that of the gate foot and that deposited over the multilayer resist mask.

The two-step formation of the control gate 13, with thermal treatment after the formation of the gate foot 11, allows to overcome the physical limits imposed by the tempering temperature in presence of low resitivity metallization (Au or Al) of the gate head 12: the latter, indeed, if subjected to temperatures close to fusion temperature (660°C for Al and 1064°C for Au), or alloying temperature with gate foot metallization 11, may be deformed not maintaining the original geometry obtained after deposition, may reduce the overall resitivity of the metallization of the control gate 13, being the alloys of such metals more resistive, and may diffuse in the barrier layer 4, thus worsening the rectifying features of the Schottky contact. Such limitations may be instead overcome by using the thermal annealing treatment after the metallization deposition of the gate foot 11 in absence of that of the gate head 12, thus allowing to use metals which are not necessarily compatible with the high temperature thermal cycles used in the step of forming the gate foot 11.

Another advantage of the two-step formation of the control gate 13 consists in the possibility of using, in the lithographic steps, a thinner photolithographic resist layer for the deposition of the gate foot 11, which makes the making of junctions of a few tens of nanometers less critical, than that for gate head deposition 12, in which the need for thicker metal deposition (hundreds of nm) for abating the parasitic resistance of the control gate 13 make it necessary to use a thicker resist.

Furthermore, the two-step constructive process of the control gate 13 allows to vary the properties of the latter so that the electric features of the HEMTs in the MMIC have optimized features for each RF function, e.g. by adapting different sizes of the gate foot 11 according to the required application, starting from the semiconductor material itself, with respect to those available by a single type of transistor which performs the various RF functions.

This leads to a modular technology adapted to various applications without needing to change the features of the semiconductor material of which the HEMT 1 is made, thus avoiding to consequently modify the manufacturing processes required for developing new functions.

It is further accessible to make transistors optimized for multiple RF functions on a single MMIC, with economic advantages, above all during the step of assembly with respect to the current making of modules in which multiple MMICs, each optimized for each RF function, are present.

Furthermore, a multifunctional MMIC based on the constructive process object of the invention allows to optimize the features of each HEMT used in the MMIC, thus improving its global features with respect to an MMIC in which the electric features of the HEMT were in common to all the RF functions.

The metallization deposition of the gate foot 11 of the control gate 13 only inside the opening 10 by selective deposition by means of a lift-off process allows to avoid the removal process of the refractory metal used for the Schottky junction present on the entire surface of the wafer outside the control gate 13, without even the need for excessive chemical etching for removing the outer insulating surface of the definition mask of the gate head 12 of the control gate 13, which removal, being obtained by bombarding the surface of the semiconductor, may worsen the features of the underneath semiconductor material in the outer region of the device of the control gate 13, especially in the case of a planar process, i.e. without recesses, such as that generally used for manufacturing GaN HEMTs.

The selective deposition by means of a lift-off process of the metallization of the gate foot 11 of the control gate 13 allows to make the metallization of the integrated Schottky field plate present in the opening 10' consisting only of the metallization of the gate foot 11' (thus not superimposed on the low resitivity metallization 12) and made in proximity of the opening 10 for the control gate 13'.

Such a result could not be obtained with a process of the type described in EP 0 592 064, because the refractory Schottky metal etching process would not comprise that present under the gate head mask, while it would removed it everywhere outside: indeed, if the opening 10' were outside the covered portion of the gate head 12', the metallization of the gate foot 11' would be removed by the chemical etching process, while if it were inside, instead, as desired so that the Field Plate can better control the electric fields in proximity of the control gate, the chemical etching would not remove the metal present from between the openings 10 and 10', because it is covered by the gate head metallization, which thus forms a mask for the etching of the metal underneath, and this creates an electric continuity between the feet 11 and 11', fact undesired to be able to bias the gate foot 11' at the optimal potential.

It is worth noting that the superimposing of a low resitivity metallization at the metal of the gate foot 11' is to the advantage of the high frequency gain of the device because the higher resistance of the Field Plate contributes to decreasing the RF loss connected to its presence.

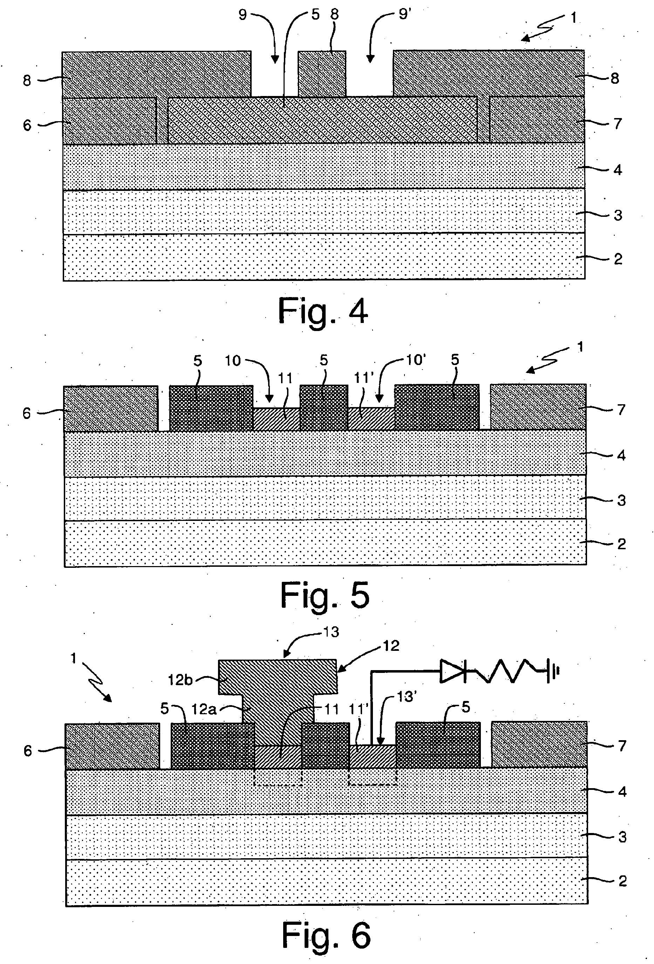

Figures 4-6 schematically illustrate in section a HEMT according to the invention, which can be made on the same semiconductor substrate at the same time as the previously described example, and thus can be integrated in the same MMIC monolithic integrated circuit. In particular, the HEMT shown in Figures 4 and 5, indicated as a whole by numeral 1', differs from the HEMT 1 illustrated in Figures 1-3 in that it is provided with a field plate electrode, indicated by 13', formed on, and in Schottky contact with the barrier layer 4, between the gate 13 and drain 7 electrodes, from which it is laterally separate.

In particular, the control gate 13, which is used to modulate the input signal, is made next to the source electrode 6, while the field plate electrode 13', which indeed performs the function of Schottky field plate for mitigating the electric field in the HEMT 1', increasing the reliability and robustness thereof and reducing the short channel effects to the advantage of RF gain of the HEMT 1', is made in proximity of the drain electrode 7. In this embodiment, the thermal stabilization and annealing treatment aimed at removing the damage introduced in the previous process steps involves both feet 11 and 11'.

In order to make the field plate electrode 13', a further through window, indicated by numeral 10', is made in the mechanical protection and/or passivation layer 5, at the same time as the through window 10. The second window 10' may also be sized in the order of a few tens of nm and is interposed between the window 10 and the drain electrode 7, from which it is laterally separated, and exposes a further barrier layer surface 4 defining a Schottky contact region in which at the same time as the formation of the gate foot 11 of the control gate 13, only the gate foot, indicated by numeral 11', of the field plate electrode 13', is made, which gate foot performs the function of Schottky field plate for mitigating the electric field within the HEMT 1', and to increase the reliability and robustness thereof, and reduce the short channel effects to the advantage of RF gain of the HEMT 1'.

Optionally, before metallization deposition on the feet 11 and 11' of the control gate 13 and of the field plate electrode 13' a chemical etching of the barrier layer 4 may be made at the windows 10 and 10' so as to make recesses in the barrier layer 4, illustrated in Figure 6 with a dashed line, so that the metallization of the feet 11 and 11' of the control gate 13 and of the field plate electrode 13' penetrate partially into the barrier layer 4. In a variant (not shown) using different masks it would be possible to make only one of the two recesses, conveniently only the one at the gate foot 11 of the control gate 13, the latter being the configuration which allows to limit the choking effect caused by the presence of the field plate electrode 13'.

The described manufacturing process allows to make a field plate electrode 13' with the same metallization used for making the gate foot 11, and this field plate electrode 13' has a greater resistance, with advantages on RF gain, and the absence of a gate head in the field plate electrode allows to obtain smaller side sizes, allowing to arrange the window 10' in which the field plate 13' electrode is made in greater proximity to the window 10 in which the control gate 13 is made, to the advantage of electric field distribution control in the HEMT channel in proximity of its peak value.

According to a different aspect of the present invention, the field plate electrode 13' is electrically connected to a ground electric potential, or more in general to a reference electric potential which could also be different from the electric ground potential by means of a region of the channel region of the HEMT 1'.

The reason for this solution consists in that the field plate electrode 13' has the function of decreasing the electric field in the channel by virtue of the electrons of the channel provided by the Schottky junction, otherwise indicated as Field Plate effect and thus improving the reliability of the HEMT 1'. Because the field plate electrode 13' never needs to carry a RF signal and a static electric field is applied instead, reducing its resistance by superimposing a gate head metallization as in the control gate 13 is not necessary, and thus the making of a Schottky junction with Field Plate effect with metallization of the gate foot 11' only facilitates its collocation in proximity of the control gate 13, so as to modulate the voltage drop in the channel of the HEMT 1' between the control gate 13 and the drain electrode 7, thus allowing to control the electric field in such a zone by decreasing the peak value thereof, and consequently mitigating the associated risks for reliability and HEMT 1', such as reverse piezoelectricity or charge generation for impact ionization.

The field plate electrode 13' also has the further protective function of limiting both the current which flows through the control gate 13, by shielding and collecting the charge in excess generated by the impact ionization phenomena, and limiting the maximum drain current if the control gate 13 exceeds the driving voltage of a Schottky diode. Indeed, the field plate electrode 13' being connected to a fixed voltage limits the current from the channel because this biased junction has the effect of emptying the electrons present under such a junction thus limiting the current which flows into the channel according to its electric potential.

In order to avoid this electric potential from having an excessive limiting effect on the maximum drain current, thus compressing the RF signal width dynamics at the terminals of the drain electrode, the electric connection of the field plate electrode 13' can be made through an appropriate electric circuit integrated with the HEMT 1' and comprising a rectifying contact, outside the channel region of the HEMT 1' and distant from the rectifying contact constituted by the Schottky junction formed by the field plate electrode 13', and an additional electric resistor in series to the rectifying contact, so that, in the operative electric biasing conditions of the HEMT 1', the field plate electrode 13' is self-biased taking the electric potential of the Schottky junction of the field plate electrode to positive values close to the driving voltage of the Schottky junction.

This can be made for example by putting the second field plate electrode 13' into contact with the anode of a diode, which, in turn, has the cathode connected to ground through a resistive element, as schematically shown in Figure 6.

By virtue of a connection of this type, the field plate electrode 13' is self-biased at a knee voltage of a diode (typically +1 V, if the diode is made with a Schottky with the electrons in GaN), preventing in this manner the channel of the HEMT 1' from remaining choked by the field plate electrode 13' when the RF signal applied to the control gate 13 reaches positive voltage values. Furthermore, the presence of a resistive network between field plate electrode 13' and ground allows to limit RF signal output loss because the parasitic capacitance of the second field plate electrode is not directly connected to ground through a short circuit but through a RC series filter.

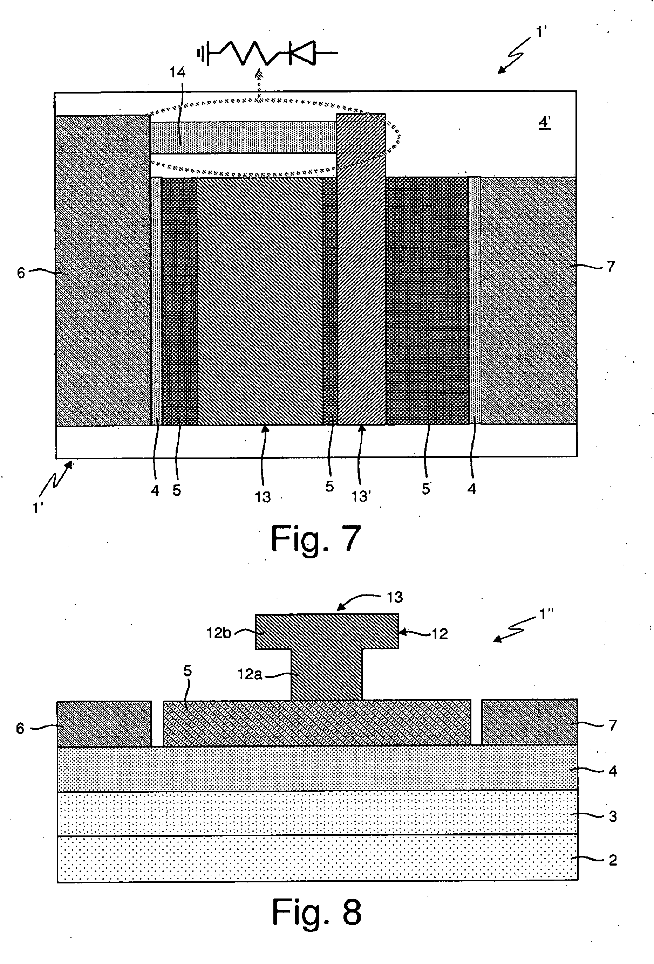

The connection to an electric ground potential of the field plate electrode 13' with the features described above may be conveniently made so as to be integrated in the same MMIC, as schematically shown in Figure 7. In particular, during the electric insulation step of the area, indicated in Figure 7 with 4', of the barrier layer 4 outside the active area of the HEMT 1, forming in this area, by means of an appropriate patterning of the protection mask, a resistive strip 14 of semiconductor material, having a first end electrically connected to the field plate electrode 13', thus forming a Schottky junction with the latter, and a second end electrically connected to ground by means of an ohmic contact.

In the example shown in figure 7, the connection of the resistive strip 14 to an electric ground potential is preferably made by superimposing a second end of the resistive strip 14 to the source electrode 6, which is generally connected to ground. The superimposition of an end of the resistive strip 14 and the field plate electrode 13' makes the rectifying contact with the required features described above, the capacitance of which can be controlled according to the area of the superimposition between resistive strip 14 and the field plate electrode 13'. Furthermore, such a superimposition allows to make, in combination with the geometry of the resistive strip 14, which regulates its resistance R, the combination of the series resistance and capacitance values (RC) to obtain the required RF insulation of the field plate electrode 13'.

The same advantages of the previously described embodiment illustrated in figure 7 could be obtained by omitting the rectifying contact and connecting the field plate electrode 13' to a positive reference electric potential, more in general not negative, of value such as to cause the choking of the channel of the HEMT 1', by means of a electric resistance.

Furthermore, according to a variant (not shown) the electric connection of the field plate connector 13' to the ground potential can be made by means of an electric circuitry comprising several rectifying contacts in series, conveniently two, outside the HEMT channel and distinct from the rectifying contact constituted by the Schottky junction defined by the metallization of the gate foot 11' with the barrier layer 4, and possibly an additional electric resistance in series to the rectifying contacts.

The two-step constructive approach described above thus allows to make both single control gate HEMTs which are more appropriate to the low noise amplification function and HEMTs in which the control gate is combined to a field plate electrode which have advantages in the power amplification function with a single constructive process, with potentials of making integrated semiconductor devices with optimized features for different functions, especially those intended for high frequency applications, on the same monolithic circuit.

Another potential advantage of the two-step constructive approach of the control gate 13 consists in the possibility of using the metallization deposition of the gate head 12 also without having previously performed the metallization of the gate foot 11, thus making HEMTs with Metal-Insulating Semiconductor electrodes (MIS), as shown by way of example in figure 8 and indicated by numeral 1", or the metallization of the gate foot 11 only, also without needing to deposit the metallization of the gate head 12, thus making HEMTs with Schottky control gates of particularly small physical size, of the type shown in figure 2. In such a manner, it is possible to optimize the performance of the HEMT according to the integrated circuit to be made without because of this introducing further technological manufacturing steps, for the advantage of constructive simplification and consequent economic and manufacturing efficiency benefits.

Such possibilities are suited to be used in integrated electronic devices also comprising HEMTs optimized for switching operations, in combination to single control gate HEMTs and/or HEMTs with control gate and field plate electrode with signal amplification function of the described and illustrated type. Indeed, the HEMTs with MIS control gate allow to obtain a lower insertion loss and a greater robustness in on state by virtue of the higher signal charge associated to an insulation and a robustness to high voltages in the off state not lower than those obtained with a device with a Schottky junction.

In the case of HEMTs with Schottky control gate defined by the gate foot 11 only, there is the possibility of inserting several control gates over the channel region of the HEMT at a distance of a few microns from the source and drain electrodes, thus making a structure similar to that shown in figure 5, by virtue of which it is possible to multiple by a factor close to the number of control gates over the HEMT channel region both the maximum voltage applicable to the HEMT input and the HEMT RF insulation in off state, and at the same time to contain the parasitic resistance of the channel in on state by virtue of the reduced distance between the source and drawing contacts.

The manufacturing of HEMTs for RF signal switching applications is advantageous in connecting the electrode or control gates 13 over the HEMT channel by means of the resistive elements which, as known in the prior art, have the function of decreasing the RF signal loss towards the outside of the HEMT. In a preferred embodiment, such resistive elements may be conveniently made in integrated form within the MMIC defining the electrically conductive semiconductor areas outside the HEMT channel, during the step of electric insulation, as previously described for making the resistive element for the ground connection of the field plate electrode 13'. The making of the control gate with metallization of the gate foot only has the further advantages of better resitivity of such metallization, thus further contributing to decreasing the RF signal losses towards the outside of the HEMT.

It is finally apparent that changes and variations can be made to the described and illustrated manufacturing process without therefore departing from the scope of protection of the present invention, as defined in the appended claims.

In particular, acceptor doping impurity ions can be implanted both in the HEMT 1 and in the HEMT 1, in manner aligned to the control gate 13, e.g. Carbon (C) or Iron (Fe), under or superimposed on the channel region which is formed under the control gate 13, between the buffer layer 3 and the barrier layer 4, in proximity of the gate junction to improve the short channel effect. The object of such ion implantation is to favor the gain increase of the HEMT 1 and 1' in low gate current and/or high drain voltage biasing conditions, to be applied above all in the case in which the length of the control gate is too short to control the short channel phenomena. Indeed, the selective implantation under the channel of the control gate 13, allows to confine the channel electrodes because the doping with implanted impurities acts as barrier to the diffusion of the channel electrons. This implantation also has the effect of reducing the electric fields in proximity of the junction, contributing to limiting the parasitic gate current the biasing being equal. With respect to the other solutions in which such doping is made uniformly on the surface of the wafer during the step of epitaxial growth, the implantation provides the same effect without decreasing the charge of the channel everywhere, thus allowing to not increase the parasitic access resistances to the intrinsic device with the limitations in the performance of GaNHEMTs of the prior art, such as those described in the introductory part and originated from the use of semiconductor material the buffer of which is acceptor impurity doped throughout.

In a preferred embodiment, the ionic implantation of acceptor impurities may be made by means of the dielectric layer before making the gate foot 11, so that the presence of such a dielectric layer used may act as encapsulator during the thermal annealing cycle after ion implantation itself, which is necessary to remove the crystal lattice damage consequent to the impact of the implanted ions, thus protecting the semiconductor crystal from contaminations with impurities present in the atmosphere used during the tempering process and/or decomposition phenomena of the crystal consequent, for example, to the leakage of nitrogen present in the crystal. Such a thermal annealing cycle could be paired to the alloying cycle of the source 6 and drain 7 electrodes, and/or during the thermal cycle made after the deposition of the metallization of the gate foot 11.

The acceptor impurity ion implantation may thus be performed either by means of a mask applied before defining the gate foot 11, or by using the same masking layer 8 used for defining the gate foot 11. This latter case allows to have two further advantages:
- the first advantage regards the performances of the HEMT, because the implanted acceptor impurities are confined to a very narrow area under the Schottky junction, thus limiting the increase of access resistances, also increasing the charge compensation to cancel out the concentration of two dimensional electron gas (2DEG) with the control gate biased at 0 V (HEMT enhanced);
- the second advantage concerns the manufacturing simplicity because the acceptor impurity ion implantation is self-aligned with the control gate 13, thus canceling the criticalities of the alignment with the formation of the gate foot 11, and it is not necessary to perform other technological steps for masking and tempering the implantation.

Making the selective acceptor impurity ion implantation, in particular for power devices, so that their doping is made in proximity of the control gate 13 with a greater extension towards the drain electrode 7, through an appropriate opening of the mask for the implantation if made before defining the gate foot 11, the effect of decreasing the concentration of electrons in the channel is obtained on the side facing the drain electrode 7 with respect to the control gate 13, thus allowing to make a doping profile similar to that implemented in Low Doping Drain (LDD) MOSFET devices made of Silicon (Si), obtaining benefits similar to those described in the introductory part with reference to the prior art. A similar distribution of acceptor impurities obtained by means of selective ion implantation may be combined also with the manufacturing of a field plate 13' electrode (Figures 4-6), and in particular made through two openings 9 in the masking layer 8.

## Claims

1. A process of manufacturing a high electron mobility transistor (1; 1'), comprising:
• providing an epitaxial substrate comprising a semi-insulating substrate (2), a buffer layer (3), and a barrier layer (4) sequentially stacked;
• forming first and second current conducting electrodes (6, 7) on, and in ohmic contact with, the barrier layer (4); and
• forming a control gate (13) and one or more field plate electrodes (13') on, and in Schottky contact with, the barrier layer (4), between the first and second current conducting electrode (6, 7);
wherein forming a control gate (13) on the barrier layer (4) comprises:
• forming a lower portion (11) of the control gate (13);
• performing a thermal stabilization and annealing treatment to remove the damage to the crystal lattice of the surface of the semiconductor introduced by the preceding process steps and stabilize the metal-semiconductor interface of the Schottky junction; and
• forming an upper portion (12) of the control gate (13) on, and in electric contact with, the lower portion (11) of the control gate (13);
**characterised in that** forming a lower portion (11) of the control gate (13) comprises:
• selectively depositing, by means of a lift-off process, a metallization comprising one or more metal elements with working function equal to or higher than 5 eV;
and **in that** forming a field plate electrode (13') comprises:
• forming only a lower portion (11') of the field plate electrode (13') which fails to protrude from the mechanical protection and/or passivation layer (5), by exploiting the same deposition by means of which the lower portion (11) of the control gate (13) is formed.

2. The manufacturing process according to claim 1, wherein forming a lower portion (11) of the control gate (13) comprises:
• forming a mechanical protection and/or passivation layer (5) on the barrier layer (4) between the first and second current conducting electrode (6, 7);
• forming a first window (10) in the mechanical protection and/or passivation layer (5) so as to expose a surface of the barrier layer (4);
• selectively depositing, by means of a lift-off process, the lower portion (11) of the control gate (13) on the exposed surface of the barrier layer (4), so that the lower portion (11) fails to protrude from the mechanical protection and/or passivation layer (5);
wherein forming an upper portion (12) of the control gate (13) comprises:
• forming the upper portion (12) of the control gate (13) on the lower portion (11) of the control gate (13), so that the upper portion (12) protrudes from the mechanical protection and/or passivation layer (5);
and wherein forming the upper portion (12) of the control gate (13) comprises:
• forming a first portion (12a), which extends laterally on the mechanical protection and/or passivation layer (5), so as to rest on, and be mechanically supported by, the latter; and
• forming a second portion (12b) vertically spaced apart, and laterally extending from either one or both of the sides of, the first portion (12a).

3. The manufacturing process according to claim 1 or 2, wherein at least one of the layers of the epitaxial substrate comprises a Nitride of a Group III element, in particular Gallium Nitride (GaN), and wherein the temperatures reached during the thermal stabilization and annealing treatment are higher than 400°C.

4. The manufacturing process according to any one of the preceding claims, wherein the first and the second current conducting electrodes (6, 7) are source and drain electrodes, respectively, the control gate (13) is formed adjacent to the source electrode (6), and the field plate electrode (13') is formed adjacent to the control gate (13), between the latter and the drain electrode (7).

5. The manufacturing process according to any one of the preceding claims, further comprising;
• electrically connecting each field plate electrode (13') to an reference electric potential by means of a rectifying contact and/or an electric resistor, wherein the rectifying contact is formed outside a channel area of the high electron mobility transistor (1') and is distinct from the rectifying contact defined by the Schottky junction formed by the field plate electrode (13').

6. The manufacturing process according to claim 5, wherein electrically connecting the field plate electrode (13') to a reference electric potential by means of a rectifying contact and/or an electric resistor comprises:
• forming an electrically non-conductive area (4') in the barrier layer (4), outside an electrically conductive area in which the high electron mobility transistor (1; 1') is formed;
• forming in the electrically non-conductive area (4') a strip (14) of semiconductor material having an electric resistance depending on the geometric dimensions and resistivity of the semiconductor material; the strip (14) having a first end electrically connected to the field plate electrode (13'), thereby forming therewith said rectifying contact, and a second end electrically connected to the reference electric potential by means of an ohmic contact.

7. The manufacturing process according to any one of the preceding claims, further comprising:
• implanting acceptor doping ions underneath the control gate (13), at the channel area of the high electronic mobility transistor (1; 1').

8. A method of manufacturing an integrated semiconductor device, comprising manufacturing:
• a high electron mobility transistor (1) as claimed in any one of the preceding claims,
and at least one of:
• a high electron mobility transistor (1'') comprising:
- an epitaxial substrate comprising a semi-insulating substrate (2), a buffer layer (3), and a barrier layer (4) sequentially stacked,
- a mechanical protection and/or passivation layer (5) formed on the barrier layer (4), and
- one or more Metal-Insulator Semiconductor control gates (13) formed on the mechanical protection and/or passivation layer (5) by exploiting the same deposition by means of which the upper portion (12) of the control gate (13) of the high mobility electron transistor (1) as claimed in any one of the preceding claims is formed; and
• a high electron mobility transistor comprising:
- an epitaxial substrate comprising a semi-insulating substrate (2), a buffer layer (3), and a barrier layer (4) sequentially stacked,
- a mechanical protection and/or passivation layer (5) formed on the barrier layer (4), and
- one or more Schottky control gates (11, 11') formed on corresponding exposed surfaces of the barrier layer (4) by exploiting the same deposition by means of which the lower portion (11) of the control gate (13) of the high mobility electron transistor (1) as claimed in any one of the preceding claims is formed.

## Patentansprüche

1. Verfahren zur Herstellung eines Transistors (1, 1') mit hoher Elektronenmobilität, das umfasst:
• Bereitstellen eines Epitaxiesubstrats, das ein halbisolierendes Substrat (2), eine Pufferschicht (3) und eine Sperrschicht (4), die nacheinander gestapelt sind, umfasst;
• Ausbilden erster und zweiter stromleitender Elektroden (6, 7) auf der Sperrschicht (4) und in ohmschem Kontakt damit; und
• Ausbilden eines Steuergates (13) und einer oder mehrerer Feldplattenelektroden (13') auf und in einem Schottky-Kontakt mit der Sperrschicht (4) zwischen den ersten und zweiten stromleitenden Elektroden (6, 7);
wobei das Ausbilden eines Steuergates (13) auf der Sperrschicht (4) umfasst:
• Ausbilden eines unteren Abschnitts (11) des Steuergates (13);
• Durchführen einer thermischen Stabilisierung und Temperung, um den Schaden an dem Kristallgitter der Oberfläche des Halbleiters zu entfernen, der durch vorhergehende Verfahrensschritte eingebracht wurde, und die Metall-Halbleiter-Schnittstelle des Schottky-Übergangs zu stabilisieren; und
• Ausbilden eines oberen Abschnitts (12) des Steuergates (13) auf und in elektrischem Kontakt mit dem unteren Abschnitt (11) des Steuergates (13);
**dadurch gekennzeichnet, dass** das Ausbilden eines unteren Abschnitts des Steuergates (13) umfasst:
• selektives Abscheiden eines oder mehrerer Metallelemente mittels eines Lift-off-Verfahrens, wobei eine Metallisierung ein oder mehrere Metallelemente mit einer Arbeitsfunktion von 5 eV oder mehr umfasst;
und dadurch, dass das Ausbilden einer Feldplattenelektrode (13') umfasst:
• Ausbilden nur eines unteren Abschnitts der Feldplattenelektrode (13'), dem es nicht gelingt, aus der mechanischen Schutz- und/oder Passivierungsschicht (5) vorzustehen, indem die gleiche Abscheidung genutzt wird, mit Hilfe derer der untere Abschnitt (11) des Steuergates (13) ausgebildet wird.

2. Herstellungsverfahren nach Anspruch 1, wobei das Ausbilden eines unteren Abschnitts (11) des Steuergates (13) umfasst:
• Ausbilden einer mechanischen Schutz- und/oder Passivierungsschicht (5) auf der Sperrschicht (4) zwischen den ersten und zweiten stromleitenden Elektroden (6, 7);
• Ausbilden eines ersten Fensters (10) in der mechanischen Schutz- und/oder Passivierungsschicht (5), so dass eine Oberfläche der Sperrschicht (4) freil iegt;
• selektives Abscheiden des unteren Abschnitts (11) des Steuergates (13) auf der freiliegenden Oberfläche der Sperrschicht (4) mittels eines Lift-off-Verfahrens, so dass es dem unteren Abschnitt (11) nicht gelingt, aus der mechanischen Schutz- und/oder Passivierungsschicht (5) vorzustehen;
wobei das Ausbilden eines oberen Abschnitts (12) des Steuergates (13) umfasst:
• Ausbilden des oberen Abschnitts (12) des Steuergates (13) auf dem unteren Abschnitt (11) des Steuergates (13), so dass der obere Abschnitt (12) aus der mechanischen Schutz- und/oder Passivierungsschicht (5) vorsteht;
und wobei das Ausbilden des oberen Abschnitts (12) des Steuergates (13) umfasst:
• Ausbilden eines ersten Abschnitts (12a), der sich seitlich auf der mechanischen Schutz- und/oder Passivierungsschicht (5) erstreckt, um darauf zu ruhen und von der Letzteren mechanisch gehalten zu werden; und
• Ausbilden eines zweiten Abschnitts (12b), der vertikal beabstandet ist und sich seitlich von einem oder beiden der Seiten des ersten Abschnitts (12a) erstreckt.

3. Herstellungsverfahren nach Anspruch 1 oder 2, wobei wenigstens eine der Schichten des Epitaxiesubstrats ein Nitrid eines Elements der Gruppe III, insbesondere Galliumnitrid (GaN), enthält, und wobei die Temperaturen, die während der thermischen Stabilisierung und der Temperbehandlung erreicht werden, höher als 400°C sind.

4. Herstellungsverfahren nach einem der vorhergehenden Ansprüche, wobei die ersten und zweiten stromleitenden Elektroden (6, 7) jeweils Source- und Drainelektroden sind, das Steuergate (13) benachbart zu der Sourcelektrode (6) ausgebildet wird und die Feldplattenelektrode (13) benachbart zu dem Steuergate (13) zwischen dem Letzteren und der Drainelektrode (7) ausgebildet ist.

5. Herstellungsverfahren nach einem der vorhergehenden Ansprüche, das ferner umfasst:
• elektrisches Verbinden jeder Feldplattenelektrode (13') mit Hilfe eines Gleichrichterkontakts und/oder eines elektrischen Widerstands mit einem elektrischen Referenzpotential, wobei der Gleichrichterkontakt außerhalb eines Kanalbereichs des Transistors (1') mit hoher Elektronenmobilität ausgebildet ist und verschieden zu dem Gleichrichterkontakt ist, der durch den Schottky-Übergang definiert ist, der durch die Feldplattenelektrode (13') ausgebildet ist.

6. Herstellungsverfahren nach Anspruch 5, wobei das elektrische Verbinden der Feldplattenelektrode (13') mit einem elektrischen Referenzpotential mit Hilfe eines Gleichrichterkontakts und/oder eines elektrischen Widerstands umfasst:
• Ausbilden eines elektrisch nicht leitenden Bereichs (4') in der Sperrschicht (4) außerhalb eines elektrisch leitenden Bereichs, in dem der Transistor (1; 1) mit hoher Elektronenmobilität ausgebildet ist; und
• Ausbilden eines Streifens (14) aus Halbleitermaterial in dem elektrisch nicht leitenden Bereich (4') mit einem elektrischen Widerstand, der von den geometrischen Abmessungen und dem spezifischen Widerstand des Halbleitermaterials abhängt; wobei der Streifen (14) ein erstes Ende, das mit der Feldplattenelektrode (13') verbunden ist, wodurch er einen Gleichrichterkontakt damit bildet, und ein zweites Ende, das mittels eines Ohmschen Kontakts mit dem elektrischen Referenzpotential verbunden ist, hat.

7. Herstellungsverfahren nach einem der vorhergehenden Ansprüche, das ferner umfasst:
• Implantieren von Akzeptordotierungsionen unterhalb des Steuergates (13) in dem Kanalbereich des Transistors (1; 1') mit hoher Elektronenmobilität.

8. Verfahren zur Herstellung einer integrierten Halbleitervorrichtung, das die Herstellung umfasst:
• eines Transistors (1) mit hoher Elektronenmobilität nach einem der vorhergehenden Ansprüche;
wenigstens eines der Folgenden:
• einen Transistor (1") mit hoher Elektronenmobilität, der umfasst:
- ein Epitaxiesubstrat, das ein halbisolierendes Substrat (2), eine Pufferschicht (3) und eine Sperrschicht (4), die nacheinander gestapelt sind, umfasst;
- eine mechanische Schutz- und/oder Passivierungsschicht (5), die auf der Sperrschicht (4) ausgebildet ist, und
- ein oder mehrere Metall-Isolator-Halbleiter-Steuergates (13), die auf der mechanischen Schutz- und/oder Passivierungsschicht (5) ausgebildet werden, indem die gleiche Abscheidung genutzt wird, mit Hilfe derer der obere Abschnitt (12) des Steuergates (13) des Transistors (1) mit hoher Elektronenmobilität nach einem der vorhergehenden Ansprüche ausgebildet wird; und
• einen Transistor mit hoher Elektronenmobilität, der umfasst
- ein Epitaxiesubstrat, das ein halbisolierendes Substrat (2), eine Pufferschicht (3) und eine Sperrschicht (4), die nacheinander gestapelt sind, umfasst;
- eine mechanische Schutz- und/oder Passivierungsschicht (5), die auf der Sperrschicht (4) ausgebildet ist, und
- ein oder mehrere Schottky-Steuergates (11, 11'), die auf entsprechenden freiliegenden Oberflächen der Sperrschicht (4) ausgebildet werden, indem die gleiche Abscheidung genutzt wird, mit Hilfe derer der untere Abschnitt (11) des Steuergates (13) des Transistors (1) mit hoher Elektronenmobilität nach einem der vorhergehenden Ansprüche ausgebildet wird.

## Revendications

1. Procédé de fabrication d'un transistor à haute mobilité d'électrons (1 ; 1') comprenant :
- la fourniture d'un substrat épitaxial comprenant un substrat semi-isolant (2), une couche tampon (3) et une couche barrière (4) empilés séquentiellement ;
- la formation de première et seconde électrodes conductrices de courant (6, 7) sur, et en contact ohmique avec, la couche barrière (4) ; et
- la formation d'une grille de commande (13) et d'une ou plusieurs électrodes à plaque de champ (13') sur, et en contact Schottky avec, la couche barrière (4), entre les première et seconde électrodes conductrices de courant (6, 7) ;
dans lequel la formation d'une grille de commande (13) sur la couche barrière (4) comprend :
- la formation d'une portion inférieure (11) de la grille de commande (13) ;
- la réalisation d'une stabilisation thermique et d'un traitement de recuit pour éliminer les dégâts sur le réseau cristallin de la surface du semiconducteur introduits par les étapes de procédé précédentes, et stabiliser l'interface métal-semiconducteur de la jonction Schottky ; et
- la formation d'une portion supérieure (12) de la grille de commande (13) sur, et en contact électrique avec, la portion inférieure (11) de la grille de commande (13) ;
**caractérisé en ce que** la formation d'une portion inférieure (11) de la grille de commande (13) comprend :
- le dépôt sélectif, au moyen d'un procédé de décollement, d'une métallisation comprenant un ou plusieurs éléments métalliques ayant une fonction de travail supérieure ou égale à 5 eV ;
et **en ce que** la formation d'une électrode à plaque de champ (13') comprend :
- la formation uniquement d'une portion inférieure (11') de l'électrode à plaque de champ (13') qui ne peut pas faire saillie à partir de la couche de protection mécanique et/ou de passivation (5), en exploitant le même dépôt que celui au moyen duquel la portion inférieure (11) de la grille de commande (13) est formée.

2. Procédé de fabrication selon la revendication 1, dans lequel la formation d'une portion inférieure (11) de la grille de commande (13) comprend :
- la formation d'une couche de protection mécanique et/ou de passivation (5) sur la couche barrière (4) entre les première et seconde électrodes conductrices de courant (6, 7) ;
- la formation d'une première fenêtre (10) dans la couche de protection mécanique et/ou de passivation (5) de façon à exposer une surface de la couche barrière (4) ;
- le dépôt sélectif, au moyen d'un procédé de retrait (« lift-off process »), de la portion inférieure (11) de la grille de commande (13) sur la surface exposée de la couche barrière (4), de sorte que la portion inférieure (11) ne puisse pas faire saillie à partir de la couche de protection mécanique et/ou de passivation (5) ;
dans lequel la formation d'une portion supérieure (12) de la grille de commande (13) comprend :
- la formation de la portion supérieure (12) de la grille de commande (13) sur la portion inférieure (11) de la grille de commande (13), de sorte que la portion supérieure (12) fasse saillie à partir de la couche de protection mécanique et/ou de passivation (5) ;
et dans lequel la formation de la portion supérieure (12) de la grille de commande (13) comprend :
- la formation d'une première portion (12a) qui s'étend latéralement sur la couche de protection mécanique et/ou de passivation (5) de façon à reposer sur, et être mécaniquement supportée par, cette dernière ; et
- la formation d'une seconde portion (12b) espacée verticalement, et s'étendant latéralement à partir de l'un ou l'autre des côtés de la première portion (12a) ou des deux.

3. Procédé de fabrication selon la revendication 1 ou 2, dans lequel au moins une des couches du substrat épitaxial comprend un nitrure d'un élément du groupe III, en particulier un nitrure de gallium (GaN), et dans lequel les températures atteintes pendant la stabilisation thermique et le traitement de recuit sont supérieures à 400 °C.

4. Procédé de fabrication selon l'une quelconque des revendications précédentes, dans lequel les première et seconde électrodes conductrices de courant (6, 7) sont des électrodes source et de drain, respectivement, la grille de commande (13) est formée adjacente à l'électrode source (6), et l'électrode à plaque de champ (13') est formée adjacente à la grille de commande (13) entre cette dernière et l'électrode de drain (7).

5. Procédé de fabrication selon l'une quelconque des revendications précédentes, comprenant en outre :
- la connexion électrique de chaque électrode à plaque de champ (13') à un potentiel électrique de référence au moyen d'un contact redresseur et/ou d'une résistance électrique, dans lequel le contact redresseur est formé à l'extérieur d'une zone de canal du transistor à haute mobilité d'électrons (1') et est distinct du contact redresseur défini par la jonction Schottky formée par l'électrode à plaque de champ (13').

6. Procédé de fabrication selon la revendication 5, dans lequel la connexion électrique de l'électrode à plaque de champ (13') à un potentiel électrique de référence au moyen d'un contact redresseur et/ou d'une résistance électrique comprend :
- la formation d'une zone non électriquement conductrice (4') dans la couche barrière (4), à l'extérieur d'une zone électriquement conductrice dans laquelle le transistor à haute mobilité d'électrons (1 ; 1') est formé ;
- la formation dans la zone non électriquement conductrice (4') d'une bande (14) de matériau semiconducteur ayant une résistance électrique dépendant des dimensions géométriques et de la résistivité du matériau semiconducteur ; la bande (14) ayant une première extrémité connectée électriquement à l'électrode à plaque de champ (13'), formant ainsi avec celle-ci ledit contact redresseur, et une seconde extrémité connectée électriquement au potentiel électrique de référence au moyen d'un contact ohmique.

7. Procédé de fabrication selon l'une quelconque des revendications précédentes, comprenant en outre :
- l'implantation d'ions dopants de type accepteur sous la grille de commande (13), au niveau de la zone de canal du transistor à haute mobilité d'électrons (1 ; 1').

8. Méthode de fabrication d'un dispositif à semiconducteur intégré, comprenant la fabrication :
- d'un transistor à haute mobilité d'électrons (1) selon l'une quelconque des revendications précédentes,
et d'au moins l'un :
• d'un transistor à haute mobilité d'électrons (1'') comprenant :
- un substrat épitaxial comprenant un substrat semi-isolant (2), une couche tampon (3) et une couche barrière (4) empilés séquentiellement,
- une couche de protection mécanique et/ou de passivation (5) formée sur la couche barrière (4), et
- une ou plusieurs grilles de commande de type métal-isolant-semiconducteur (13) formées sur la couche de protection mécanique et/ou de passivation (5) en exploitant le même dépôt que celui au moyen duquel la portion supérieure (12) de la grille de commande (13) du transistor à haute mobilité d'électrons (1) tel que revendiqué dans l'une quelconque des revendications précédentes est formée ; et
• d'un transistor à haute mobilité d'électrons comprenant :
- un substrat épitaxial comprenant un substrat semi-isolant (2), une couche tampon (3) et une couche barrière (4) empilés séquentiellement,
- une couche de protection mécanique et/ou de passivation (5) formée sur la couche barrière (4), et
- une ou plusieurs grilles de commande Schottky (11, 11') formées sur des surfaces exposées correspondantes de la couche barrière (4) en exploitant le même dépôt que celui au moyen duquel la portion supérieure (11) de la grille de commande (13) du transistor à haute mobilité d'électrons (1) tel que revendiqué dans l'une quelconque des revendications précédentes est formée.
